## Europäisches Patentamt
## European Patent Office
## Office européen des brevets

(19)

(11) Numéro de publication: **0 019 546**
**A1**

(12) **DEMANDE DE BREVET EUROPEEN**

(21) Numéro de dépôt: **80400665.8**

(22) Date de dépôt: **13.05.80**

(51) Int. Cl.³: **H 05 K 7/20**

(30) Priorité: **15.05.79 FR 7912310**

(43) Date de publication de la demande:
**26.11.80 Bulletin 80/24**

(84) Etats Contractants Désignés:
**DE GB NL SE**

(71) Demandeur: **Gentric, Alain**
**27, Lotissement Keranroux**
**F-22300 Lannion, Ploubezre(FR)**

(71) Demandeur: **Le Rouzic, Jean**
**23, rue de Bourgogne**
**F-22300 Lannion(FR)**

(72) Inventeur: **Gentric, Alain**
**27, Lotissement Keranroux**
**Ploubezre F-22300 Lannion(FR)**

(72) Inventeur: **Le Rouzic, Jean**
**23, rue de Bourgogne**
**F-22300 Lannion(FR)**

(74) Mandataire: **Mongredien, André et al,**
**c/o Brevatome 25, rue de Ponthieu**
**F-75008 Paris(FR)**

(54) Connecteur thermique à verrouillage quart de tour.

(57) Connecteur thermique entre un support dissipateur (12) et un drain (14).

Le dispositif comprend une double pince (2) métallique déformable et un logement (8) central pour une clé (10) de manoeuvre à méplat. En position de repos, la clé n'agit pas sur les parois de son logement et le connecteur est déverrouillé. Tournée d'un quart de tour, la clé (10) écarte les parois de son logement, ce qui a pour effet de resserrer les joues (3'3'') des pinces sur le support et sur le drain : le connecteur est verrouillé.

Application dans les systèmes à circuits électroniques.

EP 0 019 546 A1

./...

## FIG.1

La présente invention a pour objet un connecteur thermique à verrouillage quart de tour. Elle trouve une application en électronique.

Le problème de la dissipation thermique des systèmes électroniques a reçu, dans le passé, plusieurs solutions : par ventilation forcée, par mise en place de radiateurs thermiques, par aménagement de zones de convection naturelle, par climatisation, etc... Aucune de ces solutions n'est vraiment satisfaisante : d'abord elles sont toutes onéreuses et lourdes de mise en oeuvre ; ensuite elles sont souvent moins fiables que les systèmes auxquels elles s'appliquent ; enfin, elles permettent difficilement de récupérer l'énergie évacuée.

C'est la raison pour laquelle on tente aujourd'hui de mettre au point des réseaux d'évacuation de calories qui utilisent des drains thermiques (au moyen par exemple de caloducs, de circuit d'eau, de fréon, etc...). Il s'agit là d'une véritable circuiterie thermique chargée de drainer les calories depuis leur source jusqu'à des collecteurs de dissipation ou de récupération.

Par ailleurs, de nouvelles technologies d'assemblage des composants électroniques sont apparues récemment qui font appel à des supports bons conducteurs thermiques (par exemple des supports métalliques), de sorte que le besoin se fait sentir de connecteurs aptes à relier de tels supports aux drains d'un réseau d'évacuation de calories.

Le problème de la mise au point de tels connecteurs est rendu difficile par le fait qu'ils doivent répondre à plusieurs exigences : mise en place simple et rapide, absence d'outillage spécialisé, non intervention sur les liaisons électriques.

La présente invention apporte une solution à ce problème en proposant un connecteur thermique qui est effectivement de mise en oeuvre très simple, qui n'entrave pas les connexions électriques et qui peut même participer au maintien mécanique des supports auxquels il est relié.

B 6658 RS

De façon précise, la présente invention a pour objet un connecteur thermique qui est destiné à relier un support dissipateur de calories à un drain thermique et qui est caractérisé en ce qu'il est constitué par une double pince métallique déformable, chaque pince étant constituée par deux joues épousant la forme du support dissipateur pour l'une des pinces et celle du drain thermique pour l'autre, le connecteur comprenant, entre les pinces, un logement pour une clé de manoeuvre à méplat, cette clé possédant une position de repos dans laquelle le méplat n'exerce aucune force sur les parois du logement central, les joues des pinces d'extrémité étant alors écartées et le connecteur déverrouillé, et une position de travail, obtenue par rotation de la clé d'un quart de tour par rapport à la position de repos, la clé venant alors écarter les parois du logement central et resserrer les joues des deux pinces d'extrémités, le connecteur étant alors verrouillé.

Sur ce principe, plusieurs modes de réalisation peuvent être obtenus dont certains vont être décrits à titre explicatif et nullement limitatif en référence aux dessins annexés sur lesquels :

- la fig. 1 est une vue en coupe d'un connecteur selon un premier mode de réalisation;

- la fig. 2 est une vue en perspective du même connecteur;

- la fig. 3 représente un connecteur selon un second mode de réalisation;

- la fig. 4 représente un connecteur selon un troisième mode de réalisation;

- la fig. 5 représente un connecteur permettant le raccordement à des drains de directions rectangulaires selon un quatrième mode de réalisation;

- la fig. 6 représente une coupe transversale d'un connecteur selon un cinquième mode de réalisation;

- la fig. 7 représente schématiquement un système à cartes électroniques pouvant être relié à un circuit de

B 6658 RS

drainage de calories au moyen de connecteurs thermiques conformes à l'invention.

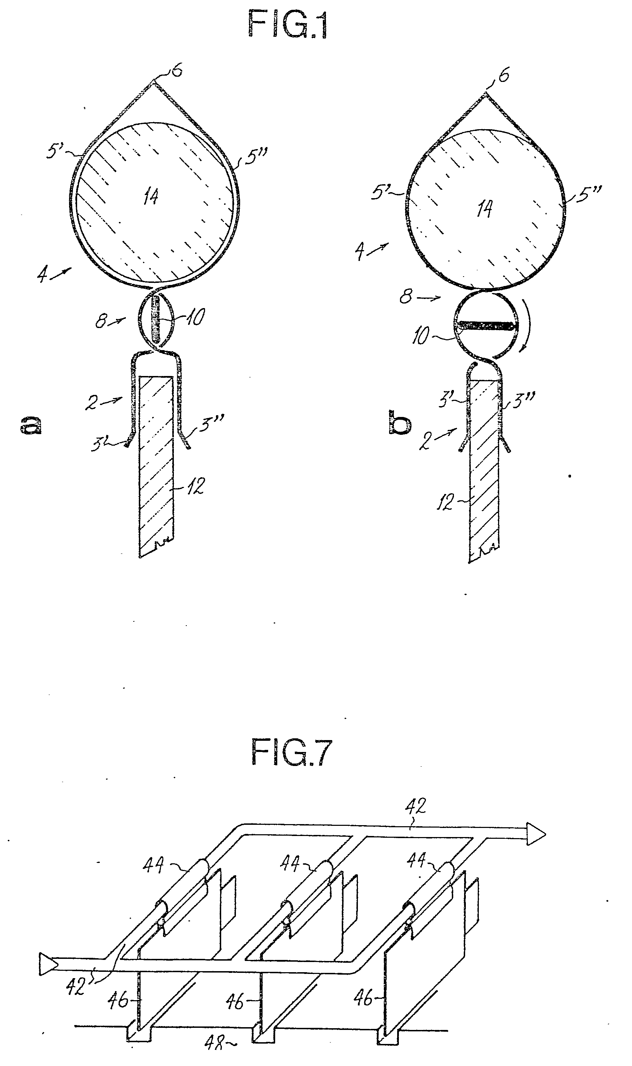

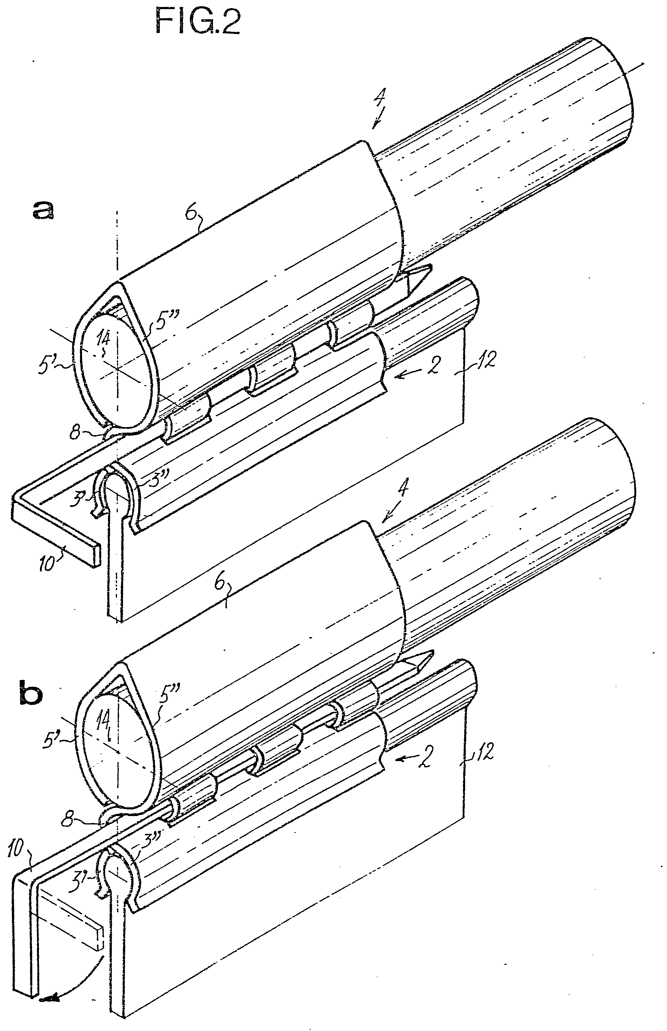

Un premier mode de réalisation d'un connecteur conforme à l'invention est illustré sur les fig. 1 et 2.

Sur la fig. 1 ce connecteur est représenté en coupe, en position non verrouillée (a) et en position verrouillée (b). Sur la fig. 2, il est représenté en perspective dans les mêmes situations : non verrouillé en (a), verrouillé en (b).

Le connecteur représenté comprend une première pince d'extrémité 2, formée de deux joues 3' et 3", et une deuxième pince d'extrémité 4, formées de deux joues 5' et 5", réunies le long d'une arête 6 formant dièdre. Dans la partie centrale du connecteur, un logement 8 reçoit une clé de manoeuvre 10 comportant un méplat. Les joues 3' et 3" formant la pince inférieure 2 sont planes, comme l'est le support dissipateur 12 sur lequel elles s'appliquent et les joues 5' et 5" de la pince supérieure sont cylindriques, comme le drain 14 qu'elles enserrent.

Le fonctionnement de ce dispositif est le suivant. Au repos, la clé est dans la position représentée sur les parties (a) des figures et la partie méplate de cette clé est dans le plan de symétrie de l'ensemble : aucune action n'est exercée sur les parois du logement 8. Les joues des deux pinces ne sont serrées ni sur le support dissipateur 12, ni sur le drain 14. Par rotation d'un quart de tour de la clé 10, le méplat est amené dans une position perpendiculaire au plan de symétrie de l'ensemble. Dans cette position les parois du logement central sont écartées, ce qui a pour effet de resserrer les joues 3', 3" sur le support 12 et les joues 5', 5" sur le drain 14.

On observera que le connecteur représenté comporte à sa partie supérieure un dièdre dont le rôle est d'assurer une certaine élasticité, d'autoriser certaines tolérances de fabrication sur le drain ainsi que de compenser d'éventuels jeux dus à la dilatation des pièces.

B 6658 RS

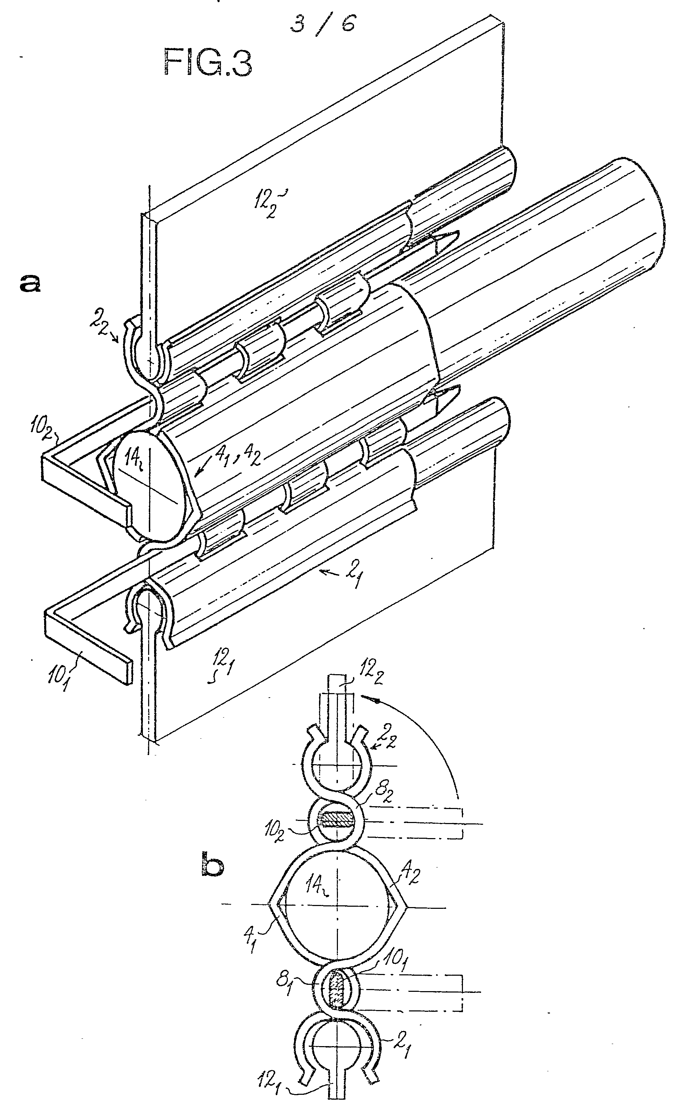

Le connecteur de la fig. 3 est représenté en perspective dans la partie (a) et en coupe transversale dans la partie (b). Dans cette variante, le connecteur comprend deux paires de pinces, la première constituée par les pinces $2_1$ et $4_1$ qui s'adaptent respectivement sur un premier support dissipateur $12_1$ et sur un drain 14, et la seconde par les pinces $2_2$ et $4_2$ qui s'adaptent sur un second support dissipateur $12_2$ et sur le même drain 14, les pinces $4_1$ et $4_2$ n'en formant donc qu'une. Une clé de manoeuvre est prévue pour chaque partie du connecteur, soit respectivement $10_1$ et $10_2$. Sur la partie (a) de la fig. 3, les deux clés sont en position de repos, et sur la partie (b) la clé $10_2$ est en position de verrouillage.

On observera que les supports dissipateurs $12_1$ et $12_2$ comportent à leur extrémité une partie renflée qui permet de mieux assurer le serrage par les joues du connecteur.

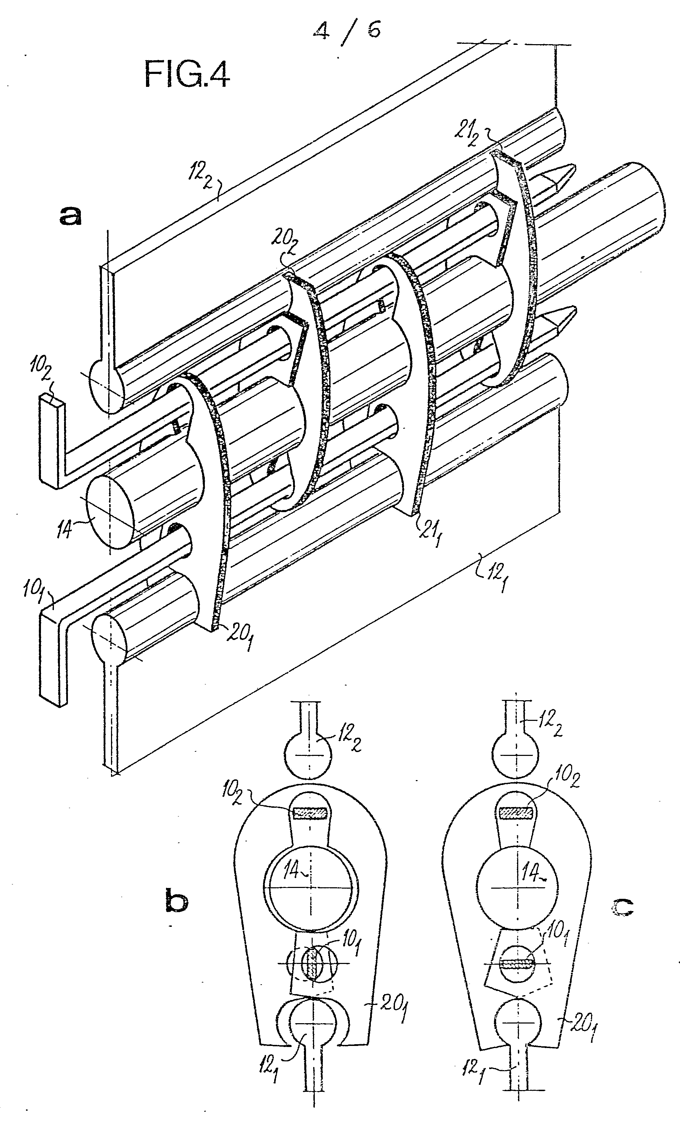

Dans les modes de réalisation des fig. 1 à 3, les éléments formant le connecteur sont obtenus par une découpe dans une bande, suivie d'une mise en forme par emboutissage ou roulage. Dans la variante illustrée sur la fig. 4, ces éléments sont constitués par des lames découpées $20_1$, $21_1$... $20_2$, $21_2$..., ce qui peut être plus simple.

Par ailleurs, le fonctionnement de ce dispositif est le même que celui de la variante de la fig. 3. Il est illustré par les parties (b) et (c) qui montrent, en coupe transversale, la position des éléments composant la partie inférieure du connecteur lorsque la clé associée $10_1$ est en position de repos (b) et en position de verrouillage (c).

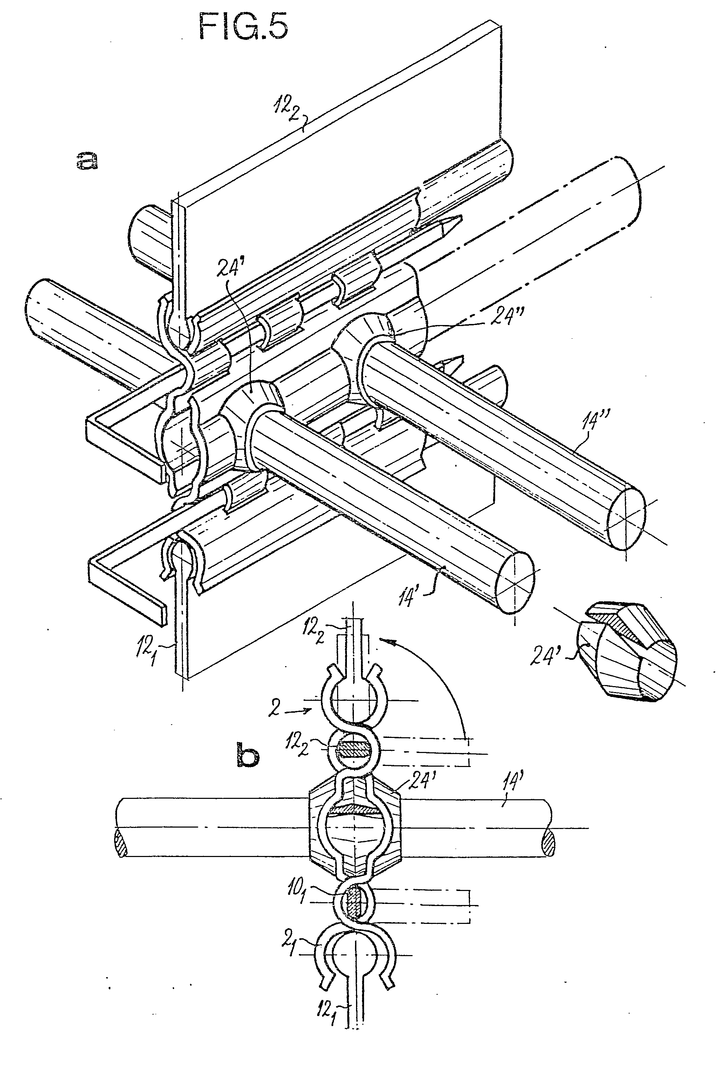

Le connecteur représenté sur la fig. 5 ne diffère de celui de la fig. 3 que par la présence de bagues fendues biconiques 24', 24"... qui reçoivent des drains cylindriques 14', 14", etc... d'axes perpendiculaires à celui du drain 14. La partie (a) de cette figure montre le connecteur en perspective avec, sur la droite, un détail d'une bague 24' ; la partie (b) représente le connecteur en coupe transversale

B 6658 RS

avec sa partie supérieure pincée sur le support $12_2$ et sa partie inférieure ouverte.

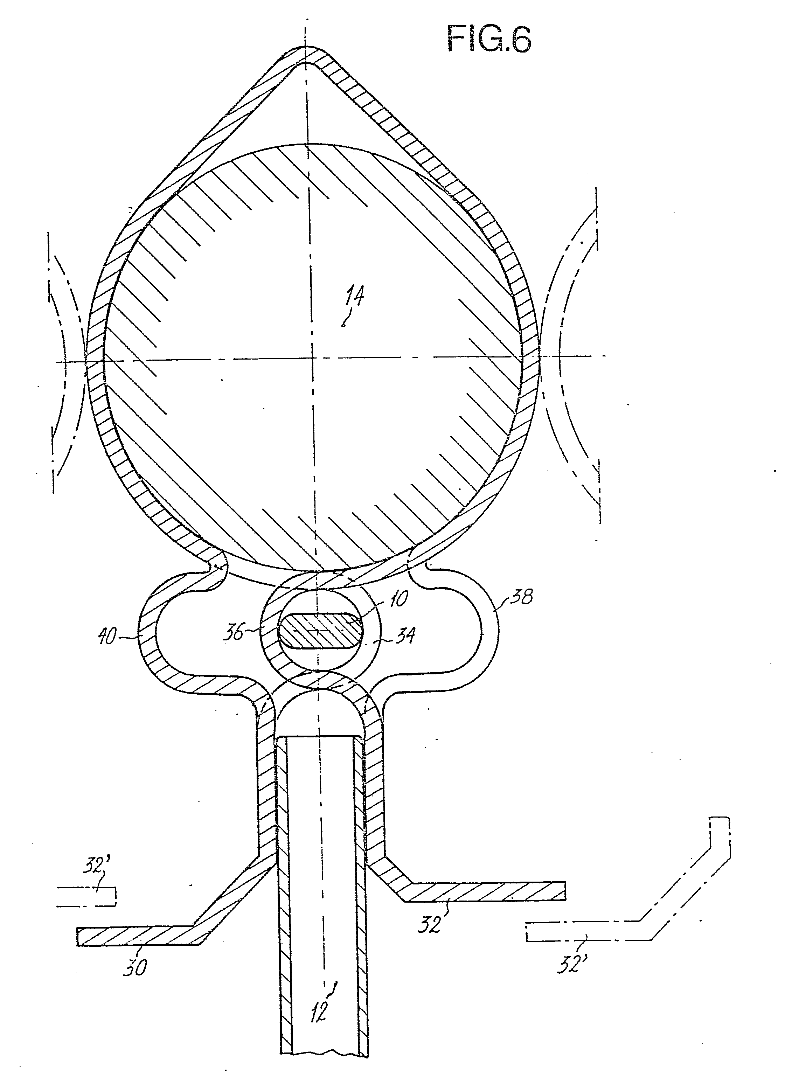

Le connecteur représenté en coupe sur la fig. 6 présente comme originalité, par rapport aux connecteurs précédemment décrits, celle de posséder des ailettes 30 et 32 à sa partie inférieure. Ces ailettes forment une chicane avec les ailettes 32' et 30" des connecteurs voisins, ce qui constitue un moyen de prélever les calories dégagées par le support dissipateur 12 en profitant des courants de convection qui atteignent ces ailettes. L'évacuation de la chaleur est ainsi améliorée. Les parties situées dans la partie centrale du connecteur sont obtenues en effectuant un crevé puis en emboutissant des pièces tantôt d'un côté, tantôt de l'autre, pour obtenir soit les joues 34 et 36 nécessaires au logement de la clé de manoeuvre 10, soit les joues 38 et 40 nécessaires au passage de la commande. Toute la section du métal est donc utilisée dans ce cas, ce qui rend la conductibilité thermique du connecteur maximale.

Il va de soi que, dans le description qui précède, le drain thermique 14 n'a une forme cylindrique circulaire qu'à titre d'exemple ; cette forme, et par conséquent celle des joues de la pince d'extrémité, pourrait être tout autre. De même pour la forme de la pince associée au dissipateur thermique, lequel pourrait ne pas être plan.

La fig. 7 représente, de façon très schématique, une installation de drainage thermique qui met en oeuvre l'invention. Cette installation comprend des drains thermiques 42 reliés par des connecteurs 44 conformes à l'invention, à des cartes 46, supports de composants électroniques dissipateurs, ces cartes étant encastrées dans un châssis 48. Le flux de conduction thermique s'établit des cartes 46 vers les drains 42 à travers les connecteurs 44, puis, par les drains, vers un collecteur non représenté.

REVENDICATIONS

1. Connecteur thermique destiné à relier un support dissipateur de calories à un drain thermique, caractérisé en ce qu'il est constitué par une double pince métallique déformable, chaque pince étant constituée par deux joues, épousant la forme du support dissipateur pour l'une des pinces et celle du drain thermique pour l'autre, le connecteur comprenant, entre les pinces un logement pour une clé de manoeuvre à méplat, cette clé possédant une position de repos dans laquelle le méplat n'exerce aucune force sur les parois du logement central, les joues des pinces d'extrémités étant alors écartées et le connecteur déverrouillé, et une position de travail obtenue par rotation de la clé d'un quart de tour par rapport à la position de repos, dans laquelle la clé vient écarter les parois du logement central et resserrer les joues des deux pinces d'extrémités, le connecteur étant alors verrouillé.

2. Connecteur thermique caractérisé en ce qu'il comprend deux connecteurs selon la revendication 1, possédant en commun une pince disposée au centre et deux pinces d'extrémités disposées symétriquement par rapport à la pince centrale.

3. Connecteur selon l'une quelconque des revendications 1 et 2, caractérisé en ce que ses parois sont réalisées à partir d'éléments découpés dans une bande puis mises en forme par emboutissage ou roulage.

4. Connecteur selon l'une quelconque des revendications 1 et 2 caractérisé en ce qu'il est formé de lames découpées.

5. Connecteur selon la revendication 2, caractérisé en ce que la pince centrale est munie de bagues biconiques fendues, d'axes perpendiculaires à celui de la pince centrale.

## FIG.1

a

b

## FIG.7

FIG.2

0019546

FIG.3

a

FIG.4

# FIG.5

$12_2$

a

$24'$

$24''$

$24''$

$14''$

$14'$

$24'$

$12_1$

$12_2$

$2 \rightarrow$

$12_2$

b

$24'$

$14'$

$10_1$

$2_1$

$12_1$

0019546

## FIG.6

0019546

Office européen
des brevets

RAPPORT DE RECHERCHE EUROPEENNE

Numéro de la demande

EP 80 40 0665

| | DOCUMENTS CONSIDERES COMME PERTINENTS | | CLASSEMENT DE LA DEMANDE (Int. Cl. 3) |
|---|---|---|---|
| Catégorie | Citation du document avec indication, en cas de besoin, des parties pertinentes | Revendication concernée | |
| A | FR - A - 2 210 824 (TEXAS INSTRUMENTS INC.) <br> * Revendications; figure 5b * <br><br> -- | 1 | H 05 K 7/20 |
| A | US - A - 3 268 772 (NORTH AMERICAN AVIATION INC.) <br> * Revendications; figure 2 * <br><br> ---- | 1 | |
| | | | **DOMAINES TECHNIQUES RECHERCHES (Int. Cl. 3)** <br><br> H 05 K 7/20 |
| | | | **CATEGORIE DES DOCUMENTS CITES** <br> X: particulièrement pertinent <br> A: arrière-plan technologique <br> O: divulgation non-écrite <br> P: document intercalaire <br> T: théorie ou principe à la base de l'invention <br> E: demande faisant interférence <br> D: document cité dans la demande <br> L: document cité pour d'autres raisons <br> &: membre de la même famille, document correspondant |

Le présent rapport de recherche a été établi pour toutes les revendications

| Lieu de la recherche | Date d'achèvement de la recherche | Examinateur |
|---|---|---|
| La Haye | 30-07-1980 | VAN REETH |

OEB Form 1503.1  06.78